# EUROPEAN PATENT SPECIFICATION

(11) **EP 1 657 744 B1**
(45) Date of publication and mention of the grant of the patent: **20.04.2011**
(21) Application number: 05024015.9
(22) Date of filing: 03.11.2005
(51) Int. Cl.: H01L 21/68, H01L 21/687, H01L 21/00, C30B 25/12, C23C 16/30

(54) **MOCVD equipment and nitride semiconductor growth method**
MOCVD Vorrichtung und Aufwachs-Methode für Nitrid-Halbleiter
Equipement de MOCVD et méthode de croissance de semi-conducteur de nitrure

(30) Priority: 16.11.2004 JP 2004332406; 14.06.2005 JP 2005174041
(43) Date of publication of application: 17.05.2006
(73) Proprietor: Sumitomo Electric Industries, Ltd., Osaka-shi, Osaka 541-0041 (JP)
(72) Inventor: Ueno, Masaki, 1-1-1, Koyakita Itami-shi Hyogo (JP); Yoshimoto, Susumu, 1-1-1, Koyakita Itami-shi Hyogo (JP); Matsuba, Satoshi, Itami-shi Hyogo (JP)
(74) Representative: Grünecker, Kinkeldey, Stockmair & Schwanhäusser Anwaltssozietät

(56) References cited:
- WO-A-02/18672
- US-A- 5 782 979
- US-A1- 2003 209 719

## Description

### BACKGROUND OF THE INVENTION

### Field of the Invention

The present invention relates to wafer guides, metalorganic chemical vapor deposition (MOCVD) equipment, and nitride semiconductor growth processes.

### Description of the Background Art

Japanese Unexamined Pat. App. Pub. No. 2003-174235 describes fabrication of a semiconductor light-emitting device in which an AlGaAs semiconductor layer is provided between a GaAs substrate and GaInNAs active layer. The GaInNAs active layer and AlGaAs semiconductor layer are grown using a metal-organic vapor deposition (MOCVD) tool. A susceptor cover is employed in growing the AlGaAs semiconductor layer on the GaAs substrate, and the GaInNAs active layer is grown without using the susceptor cover. With this semiconductor light-emitting device, because the aluminum impurity content in the active layer is low, light-emitting characteristics are greatly improved.

In Pat. App. Pub. No. 2003-174235, in fabricating a light-emitting device using a GaInNAs active layer and AlGaAs cladding layer, a susceptor cover as mentioned above is used to reduce the aluminum impurity content in the active layer.

With MOCVD equipment for growing GaAs semiconductor materials as well as InP semiconductor materials, the susceptors, which typically are made of graphite, are treated as follows to remove deposits formed on the susceptors.
(1) Because graphite susceptors cannot be wet etched, they are vapor-phase etched using a hydrogen halide gas (e.g., hydrogen chloride gas). A hydrogen-chloride gas feed line is provided in the MOCVD tool so that the susceptor can be vapor-phase etched after removal of a substrate on which a film has been deposited. While replacement of the susceptor is not necessary, the addition of this vapor-phase etching step lowers productivity. To avoid lowering productivity would require setting up a reactor for vapor phase etching and not using the MOCVD tool, which would result in increased costs.
(2) The graphite susceptor is removed from the MOCVD tool and baked under a vacuum to remove deposits. During deposit removal, the MOCVD tool cannot be used for semiconductor-film growing, meaning that productivity is lowered. A separate susceptor or wafer tray may be used, but differences between individual susceptors or wafer trays in terms of processing precision and materials cause lack of uniformity among epitaxial films, resulting in lowered yield.
(3) A graphite susceptor may deform in being vapor-phase etched or baked under a vacuum. In such cases, susceptors on which deposits have built up to a certain extent are disposed of (thrown away). Such throwaway use increases costs, and in addition, the lack of uniformity arising from individual differences between new susceptors and old results in lowered yields.
(4) If a quartz wafer tray is placed on a graphite susceptor, GaAs and InP deposits can be easily removed by chemical etching using aqua regia.

A semiconductor light-emitting device described in Japanese Unexamined Pat. App. Pub. No. 2003-174235 employs a GaInNAs semiconductor, with nitrogen constituting only a small percentage of the GaInNAs semiconductor. Therefore, the GaInNAs semiconductor is not a so-called III-nitride semiconductor as would be expressed by the general formula: Al*ₓ*Ga*_{y}*In_{1-*x*-*y*}N (0 ≤ *x≤* 1, 0 *≤y≤* 1, 0≤ *x* + *y≤* 1).

Meanwhile, in MOCVD equipment for growing III nitrides, either the susceptors are formed of graphite coated with a material having resistance against NH₃ permeation (for example, SiC, TaC, BN or the like), or a wafer tray formed of quartz or the like is provided on the susceptors. Both the susceptors and wafer trays have pockets for receiving wafers. When epitaxial growth is carried out using such MOCVD equipment, polycrystals are deposited on portions of the susceptor and wafer other than the pockets (recesses). When such deposits become large, they break off and adhere to the deposition substrates, causing surface defects. Thus, the susceptors and wafer trays need to be replaced as necessary to eliminate the effects from such deposits. During deposit removal, III-nitride films cannot be grown, lowering productivity. Other susceptors and wafer trays may be used, but individual differences in processing precision, materials or the like can cause lack of uniformity among products or lowered yield.

Because III-nitride deposits are chemically stable, their removal is not easy. III-nitride deposits formed on a quartz jig can be removed by etching with a heated phosphoric acid solution or a mixture of phosphoric acid and sulfuric acid. However, because the etchant when heated to 150-300°C is highly reactive, the quartz is also etched little by little with each etching. As a result, the precision, for example, of the flatness of wafer tray pockets degrades with each etching. This degradation affects the properties of semiconductor devices, or lowers yields. What is more, etching shortens wafer tray life.

As just noted, graphite susceptors are coated with SiC, TaC or the like. These materials are relatively stable chemically; however, because their corrosion resistance against the above etchants has not been established, it is preferable not to etch III-nitride deposits with the above etchants. In addition, getting the susceptor-coating films to be freer of pinholes is challenging. With the presence of pinholes or the like on a coating film, etchant penetrates the porous graphite, and such penetrating etchant cannot be easily removed. Thus, to remove III-nitride deposits formed on a graphite susceptor, hydrochloride gas etching is employed in heatable etching devices.

A hydrogen-chloride gas feed line is provided in MOCVD equipment so that vapor phase etching can be carried out after removal of a substrate on which a film has been grown. However, when nitride deposits are decomposed using a hydrogen chloride gas, ammonia is produced from the disassociated nitrogen, and the reaction between ammonia and hydrogen chloride produces ammonium chloride. Ammonium chloride is in the form of a powder, and causes difficulties such as: depositing on susceptors and on exhaust systems in deposition equipment, which can be a cause of exhaust-line blockage; or becoming incorporated into epitaxial deposition layers in the form of particles, causing defects. Moreover, nitride growth cannot be carried out during nitride deposit removal, lowering productivity If for this reason another etching device is provided, the result is an increase in costs. Nitride deposits do not come off readily by being baked within a vacuum-which is effective with GaAs and InP deposits-such that bake-treating susceptors to remove nitrogen deposits requires an extremely long process time.

Providing hydrogen chloride feed lines in MOCVD equipment increases costs. Furthermore, because hydrogen chloride is a corrosive gas and poses the risk of mixing with ammonia and readily producing ammonium chloride in powered form, it is difficult to handle. For this reason, simply baking is carried out, in hydrogen at a high temperature. Baking in hydrogen decomposes and removes nitride deposits to a certain degree; complete removal, however, is difficult. In particular, nitride deposits containing Al (AlN, AlGaN, InAlGaN or the like) are difficult to remove by hydrogen baking, and will remain on a susceptor.

US 2003/0209719 A1 describes susceptor for MOCVD reactor. A susceptor for holding semiconductor wafers in an MOCVD reactor during growth of epitaxial layers on the wafers is disclosed. The susceptor comprises a base structure made of a material having low thermal conductivity at high temperature, and has one or more plate holes to house heat transfer plugs. The plugs are made of a material with high thermal conductivity at high temperatures to transfer heat to the semiconductor wafers. A metalorganic organic chemical vapor deposition reactor is also disclosed utilizing a susceptor according to the present invention.

US 5,782,979 describes substrate holder for MOCVD. A substrate holder employed for MOCVD and supporting a wafer on which crystal growth proceeds includes a molybdenum holder body, a GaAs polycrystalline film with a flat surface grown on a part of the surface of the molybdenum holder body where the wafer is absent, and an InP polycrystalline film grown on the GaAs polycrystalline film. Each of the polycrystalline films is grown to a thickness of 0.3 .mu.m or more at a temperature higher than the epitaxial growth temperature of 575.degree. C. During the MOCVD process, the emissivity of the molybdenum substrate holder is stable at a value near the emissivity of the wafer on the substrate holder and, therefore, the decomposition ratio of PH.sub.3 gas on the substrate holder is stable at a value near the decomposition ratio on the wafer, whereby any variation of the incorporation ratio of P atoms in the grown InGaAsP, i.e., a variation of the composition of the InGaAsP, is reduced and run-to-run variations of the composition of the grown crystal are reduced.

### SUMMARY OF THE INVENTION

It is the object of the present invention to improve an MOCVD tool for growing nitride semiconductor and nitride-semiconductor deposition method. This object is achieved by providing an MOCVD tool for growing nitride semiconductor according to claim 1 and a nitride semiconductor deposition method according to claim 14. Embodiments of the invention are set forth in the dependent claims.

### BRIEF DESCRIPTION OF THE DRAWINGS

Fig. 1A is a drawing illustrating a wafer support and wafer guide, and Fig. 1B is a drawing illustrating the wafer support, a wafer guide mounted on the wafer support, and wafers guided in the wafer guide on the wafer support;
Fig. 2 is a drawing illustrating one example of an MOCVD tool for growing nitride semiconductor;
Fig. 3 is a drawing depicting another example of an MOCVD tool for growing nitride semiconductor;
Figs. 4A and 4B are drawings illustrating a modified example of a wafer guide;
Figs. 5A and 5B are drawings depicting a wafer support and wafer guide utilized for wafers having an orientation flat;
Figs. 6A and 6B are drawings depicting a modified example of a wafer support;
Figs. 7A and 7B are drawings illustrating a modified example of a wafer guide;
Figs. 8A and 8B are drawings illustrating a modified example of a wafer guide, Fig. 8C is fragmentary sectional view thereof, while Fig. 8D is a fragmentary sectional view depicting a separate modified example of a wafer guide;
Figs. 9A and 9B are drawings illustrating a modified example of a wafer support and wafer guide;
Figs. 10A and 10B are drawings depicting a modified example of a wafer support and wafer guide utilizing spacers;
Figs. 11A and 11B are drawings illustrating a modified example of a wafer support and wafer guide;
Figs. 12A and 12B are drawings illustrating a modified example of a wafer support and wafer guide, while Fig. 12C is a cross-sectional view taken along the line II-II indicated in Fig. 12B;
Fig. 13 is a chart explaining a method for depositing nitride semiconductor
Fig. 14 is a chart explaining a modified example of a nitride-semiconductor deposition method; and
Fig. 15 is a chart explaining an additional step of a nitride-semiconductor deposition method.

### DETAILED DESCRIPTION OF THE INVENTION

The ideas behind the present invention can be easily understood by giving consideration to the following detailed description while referring to the accompanying drawings presented as examples. With reference being made to the attached drawings, explanation will now be given for embodiments of the present invention relating to a wafer guide, MOCVD equipment and a nitride semiconductor deposition method. When possible, identical parts have been given the same reference marks.

### [First Embodiment]

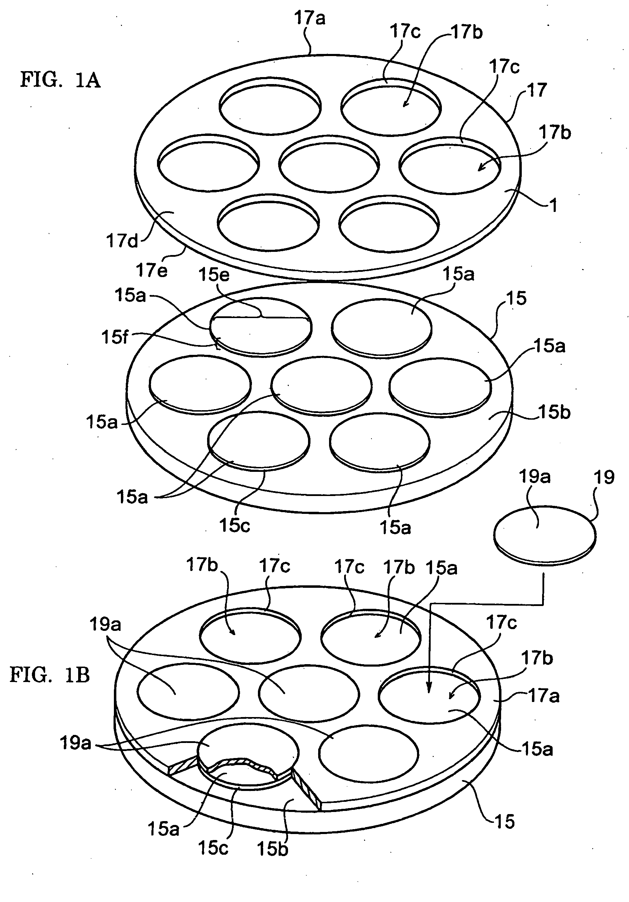

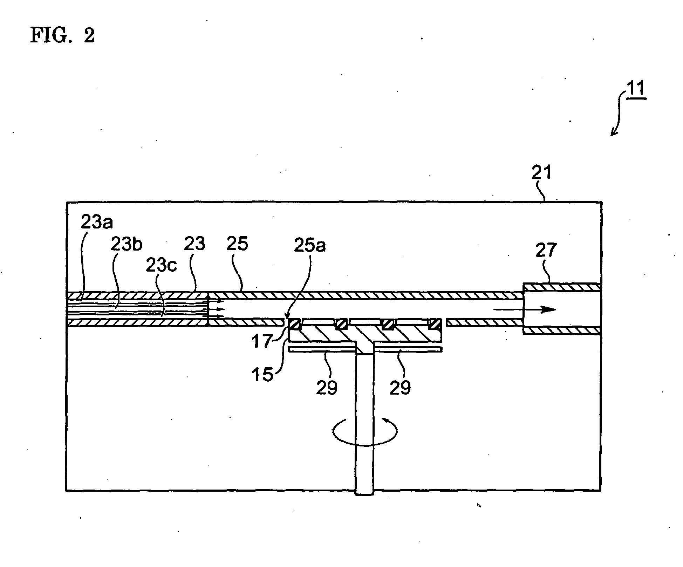

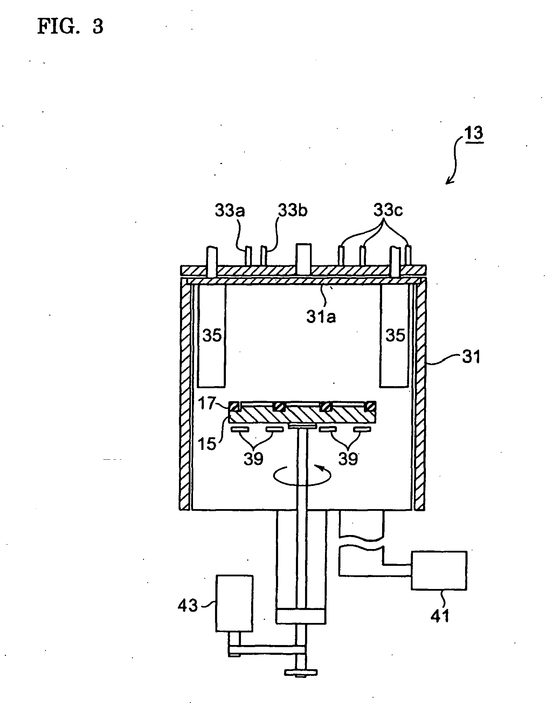

Fig. 1A depicts a wafer support and wafer guide. Fig. 1B represents the wafer support, a wafer guide mounted on the wafer support, and wafers guided by the wafer guide on the wafer support. Fig. 2 depicts one example of an MOCVD tool for growing nitride semiconductor. Fig. 3 depicts another example of an MOCVD tool for growing nitride semiconductor. MOCVD tools 11 and 13 include a wafer support 15 and wafer guide 17.

Referring to Fig. 1A and Fig. 1B, the wafer support 15 includes one or a plurality of first sections 15a, and a second section 15b surrounding the first sections 15a. Each first section 15a includes a surface for supporting a wafer 19 on which nitride semiconductor is to be deposited. The wafer guide 17 is disposed on the second section 15b of the wafer support 15 in the MOCVD tools 11 and 13. The wafer guide 17 is furnished with a protector 17a for covering the second section 15b, and one or more openings 17b for receiving the wafers 19 on the first sections 15a. The protector 17a includes lateral surfaces 17c defining the openings 17b and guiding the wafers 19, and has a first surface 17d on which III-nitride deposits and a second surface 17e on the side opposite the first surface 17d. The second surface 17e is supported by the flat surface of the second section 15b of the wafer support 15. Each opening 17b extends from the first surface 17d to the second surface 17e. The wafer guide 17 receives a wafer 19 in each opening 17b, with the wafers 19 being loaded onto the support surface of each first section 15a of the wafer support 15 exposed in each opening 17b. There is a difference in height between the first sections 15a and second section 15b, resulting in a step 15c. The height of the first surface 17d of the wafer guide 17 is made to match the height of the surfaces 19a of the wafers 19 mounted on the wafer support 15. Thus the wafer guide 17 does not disrupt the flow of reaction gas across the wafer guide 17 and wafers 19. Because disruption of gas flow is inhibited, nitride compound semiconductor with uniform and superior crystal characteristics can be grown.

With this wafer guide 17, when epitaxial growth is carried out using the MOCVD toold 11 and 13, III nitride deposits on the surfaces 19a of the wafers 19 and on the wafer guide 17 covering the entire upper surface of the wafer support 15. Thus the wafer guide 17 protects the wafer support 15 from III-nitride build-up.

The wafer support 15 may be, for example, a susceptor or wafer tray The wafer support 15 is preferably formed from carbon coated with a material resistant to permeation by NH₃ (e.g., SiC or TaC).

The wafer guide 17 is preferably formed from a material resistant to corrosion by a phosphoric acid solution or mixture containing phosphoric acid and sulfuric acid, or from a material resistant to corrosion by ammonia and hydrogen gases at high temperature, and is resistant to corrosion by phosphoric acid solutions or mixtures containing phosphoric acid and sulfuric acid. Such a wafer guide shows little wear, despite its use in growing III-nitride semiconductor films, and despite the use of the above etchants to remove III-nitride deposits. Alternatively, the wafer guide 17 is preferably formed from at least one of the following, which can be used in the technical field of III-nitride semiconductor growth: quartz, silicon carbide (SiC), tantalum carbide (TaC), or boron nitride (BN).

The MOCVD tool 11 will be explained with reference to Fig. 2. The MOCVD apparatus 11 comprehends first, second and third flow channels 23, 25 and 27 provided in a chamber 21. The first, second and third flow channels 23, 25 and 27 are disposed along a predetermined axis. The first flow channel 23 leads precursor gases to the second flow channel 25. The first flow channel 23 comprehends for example, a first line 23a in which nitrogen gas and hydrogen gas flow, a second line 23b in which a Group III metalorganic gas and carrier gas flow, and a third line 23c in which ammonia and a carrier gas flow. The second flow channel 25 has an opening 25a for receiving the wafer support 15 and wafer guide 17. The precursor gases flow over the wafer support 15 and wafer guide 17 positioned in this opening 25a. The reaction of the precursor gases cause a III-nitride film to grow on the wafers. Precursor gas residue and reaction by-product gas are exhausted via the third flow channel 27. On the bottom side of the wafer support 15, there is provided a heater 29 for adjusting wafer temperature. Heat from the heater 29 is conducted by the wafer support 15 to the wafers. If required, the MOCVD tool 11 is furnished with a rotary drive mechanism for rotating the wafer support 15.

The MOCVD tool 13 will be explained with reference to Fig. 3. The MOCVD tool 13 has within a chamber 31 a wafer support 15 and wafer guide 17. The chamber 31 comprehends a first line 33a in which, for example, nitrogen gas and hydrogen gas flow, a second line 33b in which a Group III metalorganic gas and carrier gas flow, and a third line 33c in which ammonia and carrier gas flow. Feed ports to the first to third gas lines 33a-33c look down on the wafer support 15 and wafer guide 17. Gases from the first to third gas lines 33a-33c are fed through a mesh 31a to inside the chamber 31. The chamber 31 has provided therein water-cooling jackets 35. At the bottom side of the wafer support 15, there are provided heaters 39 for adjusting wafer temperature. Heat from the heaters 39 is conducted by the wafer support 15 to the wafers. Precursor gas residue and reaction by-product gas pass through an exhaust vent to exhaust equipment 41. If required, the MOCVD tool 13 is furnished with a rotary drive mechanism 43 for rotating the wafer support 15.

Returning to Fig. 1A and Fig. 1B, the first sections 15a are demarcated from the second section 15b by the steps 15c. Because first sections 15a of the wafer support 15 each include a platform 15e protruding in conformance with the shape of the wafer 19, and because the lateral surfaces 17c of the protector 17a extend along the lateral surfaces 15f of the platforms 15e, with this wafer guide 17, the protector 17a protects the wafer support 15 from precursor gases fed into the MOCVD tools 11, 13. As a result, the wafer support 15 has a longer lifespan.

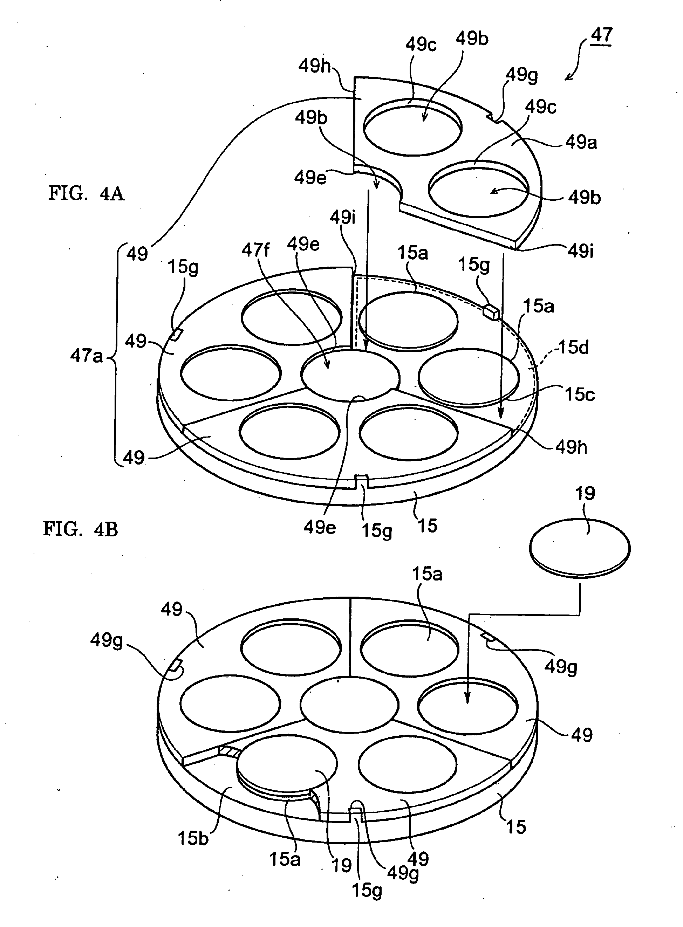

Figs. 4A and 4B represent a modified example of a wafer guide. A protector 47a of a wafer guide 47 comprehends a plurality of protection parts 49. Each protection part 49 is furnished with a protection portion 49a partially covering the surface 15d of the second section 15b. By combining all the protection parts 49 the wafer guide 47 covers the second section 15b and delineates all openings 49b and guides all wafers 19. With this wafer guide 47, because each of the protection parts 49 can be carried away or etched, a large etching bath is unnecessary for etching; further, the likelihood of the wafer guide 47 breaking when handled is small. (When wafer guides reach a certain size they break easily.)

Described in greater detail, the protection parts 49 have openings 49b for receiving the wafers. The openings 49b are delineated by curved surfaces 49c, 49e. The protection parts 49 include positioning surfaces 49h, 49i for fitting with an adjacent protection part 49 when the protection parts are to be combined. An opening 47f in the wafer guide 47 is created through the combination of the three protection parts 49. The opening 47f is delineated by the combination of the curved surfaces 49e of the three protection parts 49.

With this wafer guide 47, when epitaxial growth is carried out using the MOCVD tools 11 and 13, III nitride deposits on the surfaces 19a of the wafers 19, and on the plurality of protection parts 49 entirely covering the upper surface of the wafer support 15. Thus the wafer guide 47 protects the wafer support 15 from III-nitride build-up.

When required, the wafer guide 47 may be furnished with positioning sections 49g for removably positioning the wafer guide 47 with respect to the wafer support 15, and the wafer support 15 may be furnished with positioning sections 15g for removably positioning the wafer guide 47. With this wafer guide 47, after film growth is performed the requisite number of times, the wafer guide 47 is removed from the wafer support 15, so that replacement is of the wafer guide 47 only. As a result, there is no deterioration of the wafer guide 15 caused by deposits thereupon, and productivity does not suffer.

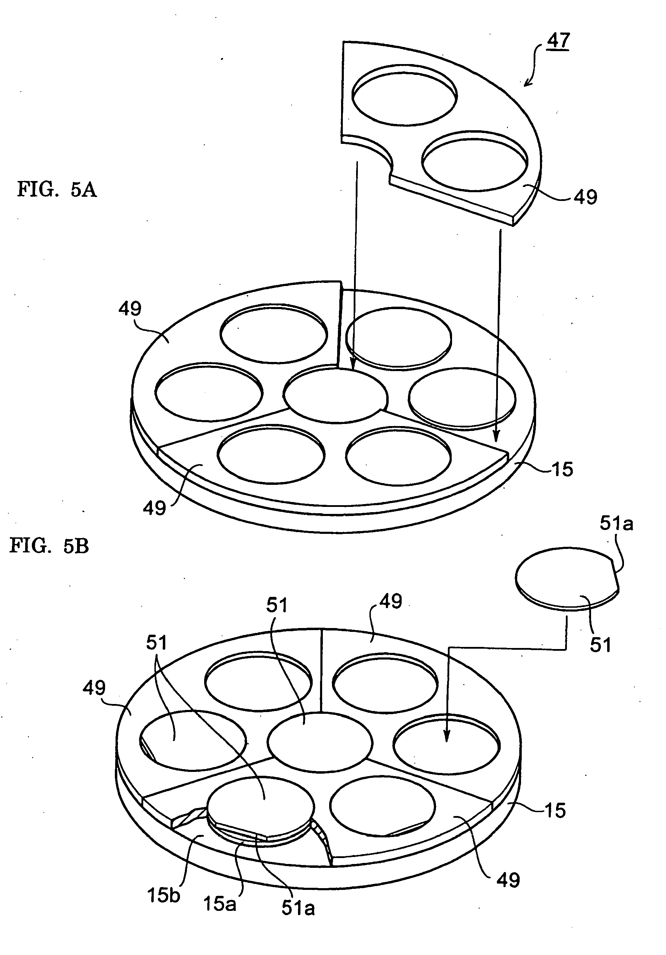

As depicted in Fig. 5A and 5B, a wafer support 15 and wafer guide 47 (17) can be used for wafers 51 having an orientation flat 51a.

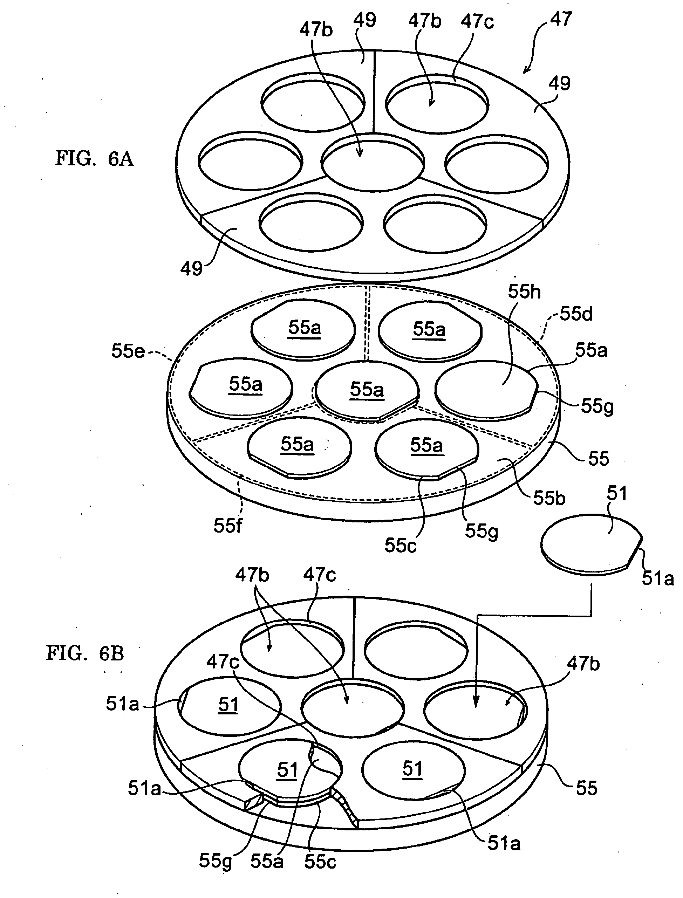

Fig. 6A and 6B represent a modified example of a wafer support and wafer guide. A wafer support 55 includes one or a plurality of first sections 55a, and a second section 55b surrounding the first sections 55a. First areas 55d, 55e, 55f of the second section 55b each carry a respective protection part 49. Each first section 55a has a support surface 55h for supporting the wafer 51 on which nitride semiconductor is to be deposited, and the support surface 55h has a linear corner 55g corresponding to the orientation flat 51a of the wafer 51. The first sections 55a are cut to a shape to conform to the orientation flats 51a, and a lateral surface (flat surface) is formed extending from the corner 55g to the second section 55b. The wafer guide 47 is provided on the second section 55b of the wafer support 55.

As shown in Fig. 6B, the wafers 51 are set into openings 47b so that the orientation flats 51a are aligned with the corners 55g of the first sections 55a. The lateral surfaces 47c of the wafer guide 47 extend along the step 55c of each first section 55a of the wafer support 55 (except for along the corner 55g), and along the edge of the wafer 51 thereupon (except for along the orientation flat 51a). Because of the corners 55g and orientation flats 51a, a portion of the second section 55b of the wafer support 55 is exposed in each opening 47b of the wafer guide 47. Because the first sections 55a are cut to a shape conforming to the orientation flats 51a, the distance between the exposed areas of the second section 55 and the obverse surface of the wafer guide 47 is increased, so that it is difficult for reactive gas in the precursor gas to reach the exposed areas of the wafer support 55.

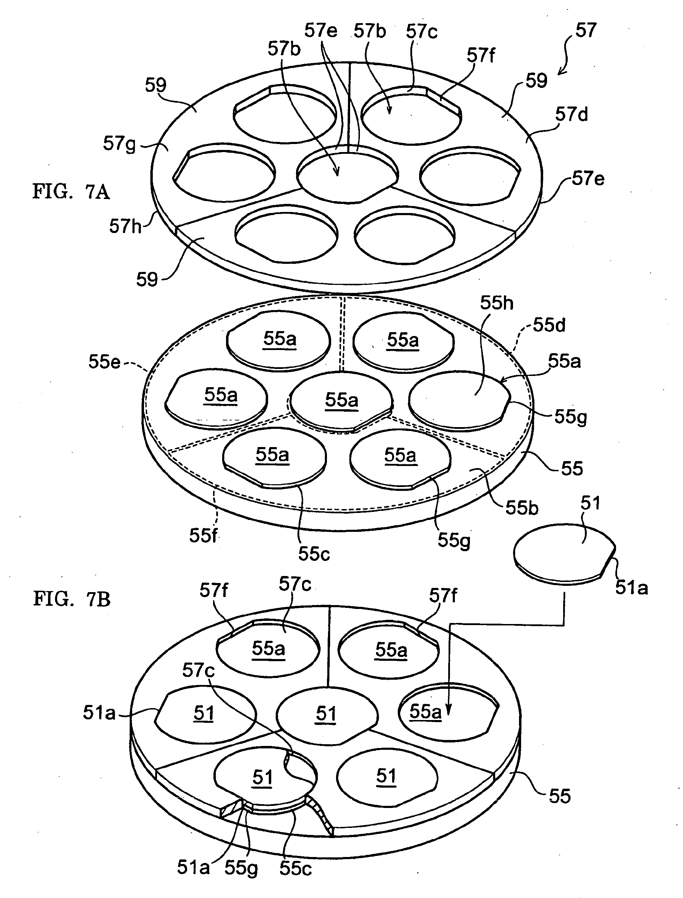

Figs. 7A and 7B depict a modified example of a wafer guide. A wafer guide 57 is provided on the second section 55b of the wafer support 55. The wafer guide 57 is furnished with protection parts 59 for covering the second section 55b, and one or more openings 57b for receiving the wafers 51 on the first sections 55a. The protection parts 59 have lateral surfaces 57c, 57f defining the openings 57b and guiding the wafers 51. The protection parts 59 have a first surface 57g on which III nitride deposits, and a second surface 57h on the side opposite the first surface 57g. The second surface 57h is supported by the support surface of the second section 55b of the wafer support 55. The wafer guide 57 receives a wafer 51 in each opening 57b, and the wafers 51 are loaded onto the support surface of each first section 55a of the wafer support 55 exposed in each opening 57b.

As shown in Fig. 7B, the wafers 51 are placed in the openings 57b so that the orientation flats 51a are aligned with the linear corners 55g of the first sections 55a. Each opening 57b includes a lateral surface 57c of the wafer guide 57, extending along the arc of the respective wafer 51, and a lateral surface 57f of the wafer guide 57, extending along the respective orientation flat 51a. The lateral surfaces 57c, 57f of the wafer guide 57 extend along the step 55c of each first section 55a of the wafer support 55 and the edge of the respective wafer 51.

Because the openings 57b are cut to a shape conforming to the orientation flats 51a, no portion of the second section 55b of the wafer support 55 is exposed, inhibiting reactive gas from encroaching to the wafer support 55.

With this wafer guide 57, the wafers 51 on the wafer support 55 are not easily displaced due to rotation. Also, the wafer guide 47 protects the wafer support 55 from the reaction gases fed into the MOCVD equipment. For this reason, the wafer support 55 has a longer lifespan.

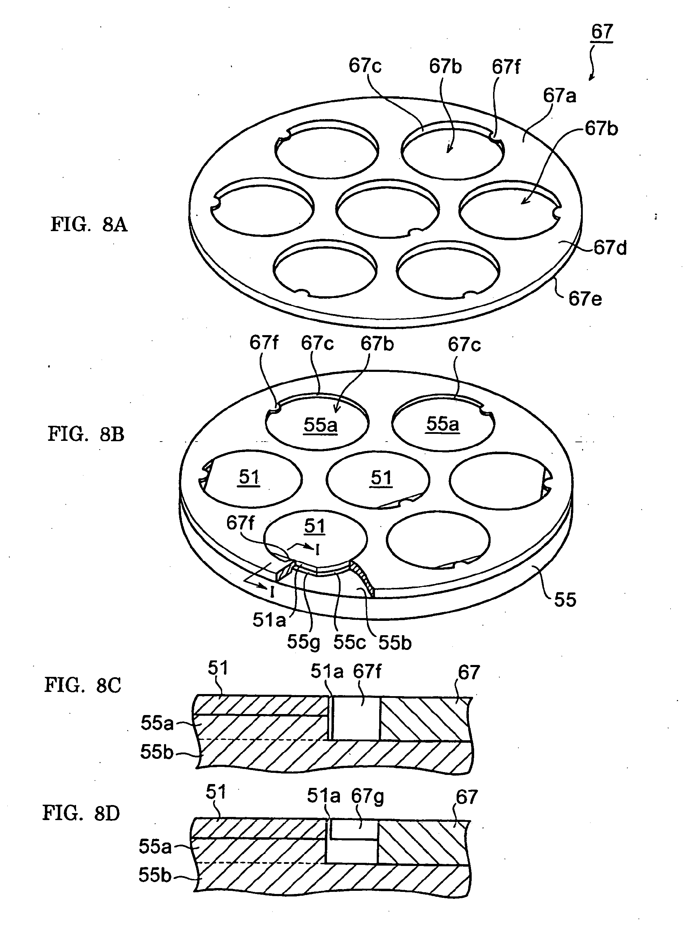

Figs. 8A and 8B depict a modified example of a wafer support and wafer guide. Fig. 8C is a cross-sectional view taken along the line I-I. A wafer guide 67 is provided on the second section 55b of the wafer support 55. The wafer guide 67 is furnished with a protector 67a for covering the second section 55b, and one or a plurality of openings 67b for receiving the wafers 51 on the first sections 55a. The protector 67a is furnished with lateral surfaces 67c defining the openings 67b and guiding the wafers 51. The protector 67a includes a first surface 67d on which III nitride deposits, and a second surface 67e on the side opposite the first surface 67d. The second surface 67e is supported by the support surface of the second section 55b of the wafer support 55.

As indicated in Fig. 8B and Fig. 8C, the wafers 51 are placed in the openings 67b so that the orientation flats 51a are aligned with the linear corners 55g of the first sections 55a. The lateral surfaces 67c of the wafer guide 67 extend along the step 55c of each first section 55a of the wafer support 55 (except for along the corner 55g), and along the edge of the wafer 51 (except for along the orientation flat 51a). Because of the corners 55g and orientation flats 51a, a portion of the second section 55b of the wafer support 55 is exposed in each opening 67b of the wafer guide 67. The wafer guide 67 has positioning protrusions 67f protruding from the lateral surfaces 67c toward the opening centers. The orientation of the wafers 51 is determined by the positioning protrusions 67f and orientation flats 51a. Because the wafer support 55, wafer 51 and wafer guide 67 undergo thermal expansion under the high temperatures in MOCVD equipment, the wafers 51 on the wafer support 55 are subject to force from the wafer guide 67 and wafer support 55 in accordance with the direction of the thermal expansion. However, because the orientation of the wafers 51 is guided by the protrusions 67f on the protector 67, the wafers 51 do not rotate freely during film growth, but are retained with the orientation of the orientation flats 51a substantially in alignment with the corners 55g; moreover, because the protrusions 67f do not have a linear form extending along the orientation flats 51a, the wafers 51 have a degree of play in the rotational direction, so that they can move in response to force received from the wafer support 55 and wafer guide 67. For this reason, no large force is applied between the wafers 51 and wafer guide 55, and the wafers 51 and wafer guide 55 breaking during growth is not an issue.

Also, cutting the first sections 55a are into a shape to conform to the orientation flats 51a increases the distance between the exposed areas of the second section 55b and the surface of the wafer guide 67, thus inhibiting reactive gases from encroaching to the exposed areas of the wafer support 55. Further, as shown in Fig. 8D, if the thickness of positioning protrusions 67g is about that of the wafer 51, the wafer guide 67 can be use in combination with a wafer support 55 regardless of whether the first section 55a has a cutaway section.

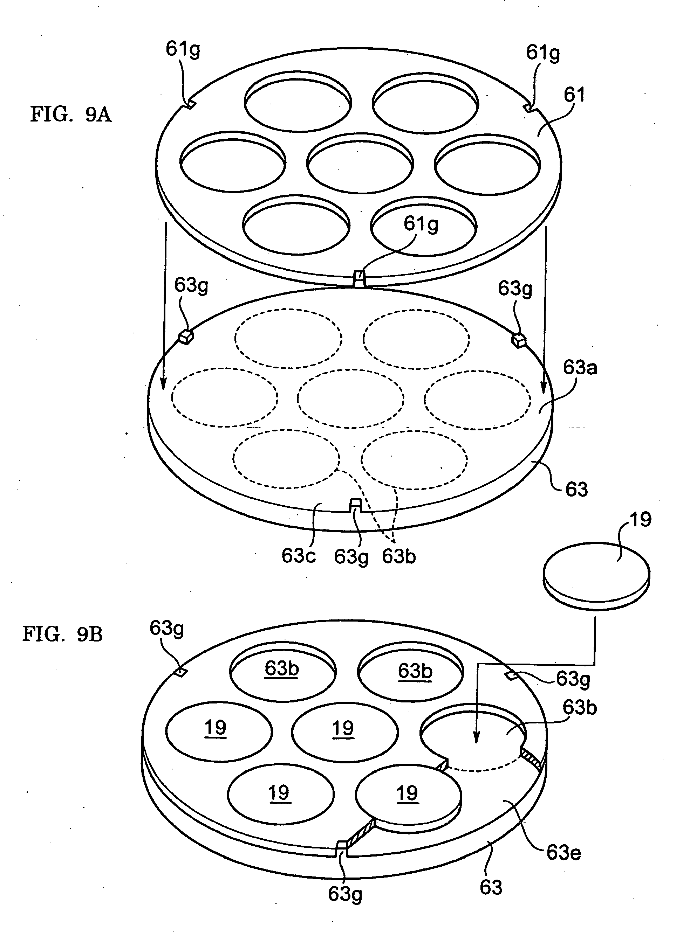

Figs. 9A and 9B illustrate a modified example of a wafer support and wafer guide not being part of the present invention. A wafer guide 61 can have the same configuration as that of the wafer guide 17 with the exception of its thickness. The wafer support 63 may include a flat surface 63a for supporting the wafer guide 61. As shown in Fig. 9B, as in the above embodiment, the wafer support 63 includes first sections 63b and a second section 63c. The thickness of the wafer guide 61 is substantially the same as that of the wafers 19. Thus the wafer support 63 can have a simple configuration, facilitating its formation. Because the flat surface 63a of the wafer support 63 is used to support the wafer guide 61, degradation of the coating on the wafer support 63 due to contact between steps on the wafer support 63 and the wafer guide 61 is prevented.

The wafer guide 61 preferably is furnished with positioning sections 61g for removably positioning the wafer guide 61 with respect to the wafer support 63, and the wafer support 63 preferably is furnished with a positioning sections 63g for removably positioning the wafer guide 61.

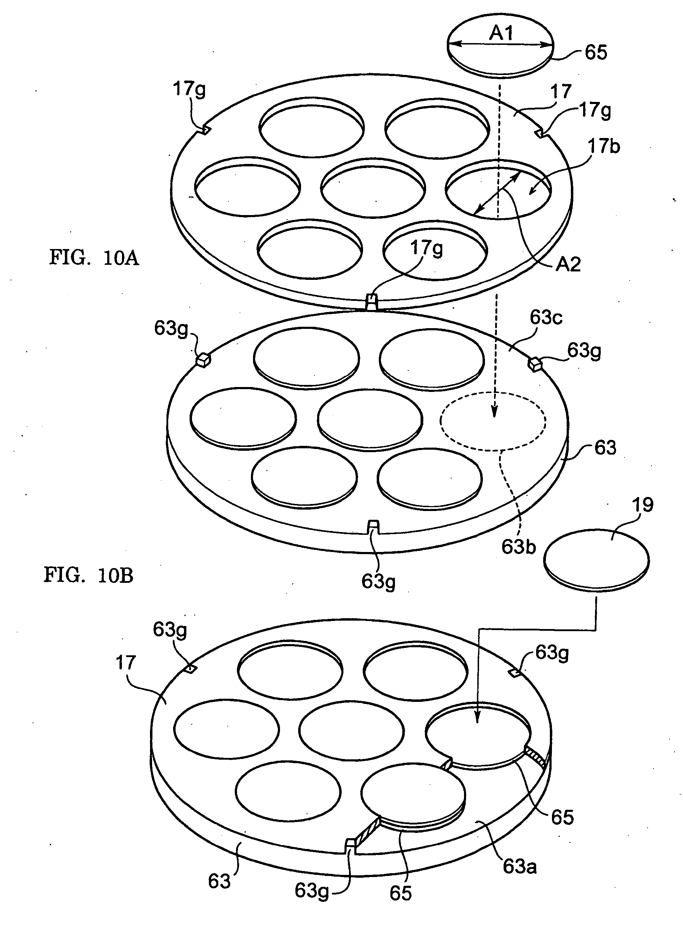

Figs. 10A and 10B represent a modified example of a wafer support and wafer guide not being part of the present invention, wherein a spacer is utilized. The MOCVD tools 11, 13 may be furnished with spacers 65 to be received by each opening 17b in the wafer guide 17. The wafer support 63 includes first sections 63b on which the spacers 65 are mounted, and a second section 63c on which the wafer guide 17 is mounted. The diameter A1 of the spacers 65 is roughly the same as the diameter A2 of the openings 17a in the wafer guide 17. The spacers 65 may be, for example, a monocrystal or polycrystal SiC plate, or a carbon plate coated with SiC or TaC, having resistance against permeation by NH₃ and superior thermal conductivity. The spacer 65 are utilized to match the surface height of the wafer guide 17 to that of the wafers 19. This makes the wafer guide 17 thicker, facilitating handling. For example, the wafer guide 17 will be less likely to break during cleaning.

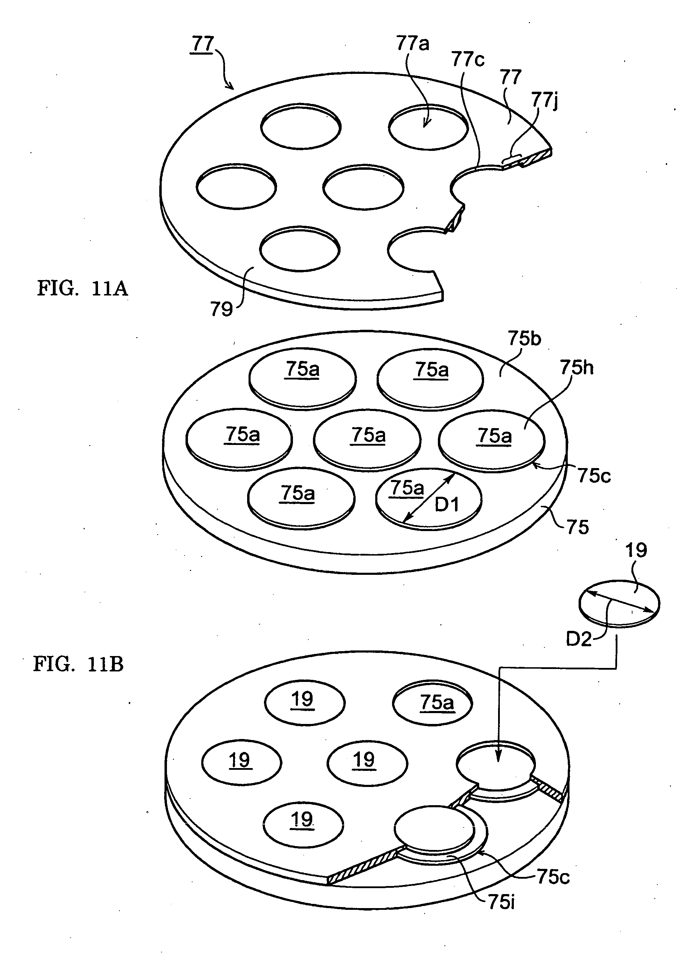

Fig. 11A and Fig. 11B show a modified example of a wafer support and wafer guide not being part of the present invention. Other than the size of the first sections 75a, the wafer support 75 has a configuration identical to that of the wafer support 15. Maximum dimension D1 of the first sections 75a of the wafer support 75 is larger than maximum dimension D2 of the wafers 19. A protector 79 of a wafer guide 77 covers an entire second section 75b, and comprehends extension portions 77j for covering the periphery of a support surface 75h of the first sections 75a. The entire support surface 75h of each first section 75a is covered with the respective wafer 19 and extension portion 77j. The extension portions 77j a include lateral surface 77c for guiding the wafer 19. The extension portion 77j becomes thinner to match a step 75c between first sections 75a and second section 75b. With this wafer guide 77, along each large support surface 75h the periphery 75i, which provides for uniformly heating the wafer 19, is covered by the extension portion 77j of the protector 79.

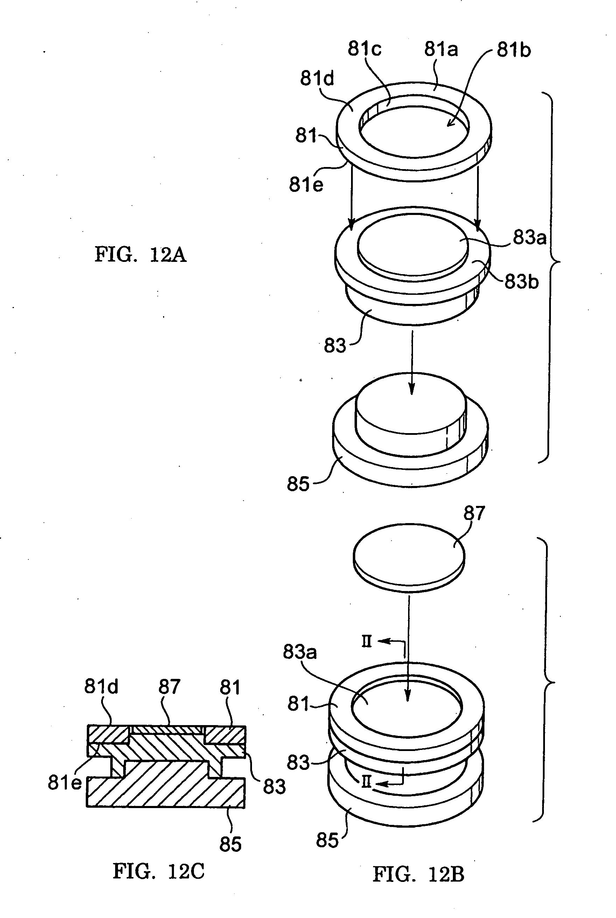

Figs. 12A and 12B illustrate a modified example of a wafer support and wafer guide not being part of the present invention. Fig. 12C is a cross-sectional view taken along the line II-II indicated in Fig. 12B. A wafer guide 81 is mounted on a wafer tray 83, and the wafer tray 83 is mounted on a susceptor 85.

The wafer tray 83 includes a first section 83a and a second section 83b surrounding the first section 83a. The first section 83a includes a surface for supporting the wafer 87 on which nitride semiconductor is to be deposited. In the MOCVD tools 11 and 13, the wafer guide 81 is provided on the second section 83b of the wafer tray 83. The wafer guide 81 is furnished with a protector 81a for covering the second section 83b, and an opening 81b for receiving the wafer 87 on the first section 83a. The protector 81a includes a lateral surface 81c defining the opening 81b and guiding the wafer 87. The protector 81a includes a first surface 81d on which III nitride deposits, and a second surface 81e on the side opposite the first surface 81d. The second surface 81e is supported by the support surface of the second section 83b of the wafer tray 83. The opening 81b extends from the first surface 81d through to the second surface 81e. The wafer guide 81 receives the wafer 87 in the opening 81b, and the wafer 87 is loaded onto the support surface of the first section 83a of the wafer tray 83 exposed in the opening 81b. As shown in Fig. 12C, the height of the first surface 81d of the wafer guide 81 matches that of the wafer 87.

### [Second Embodiment]

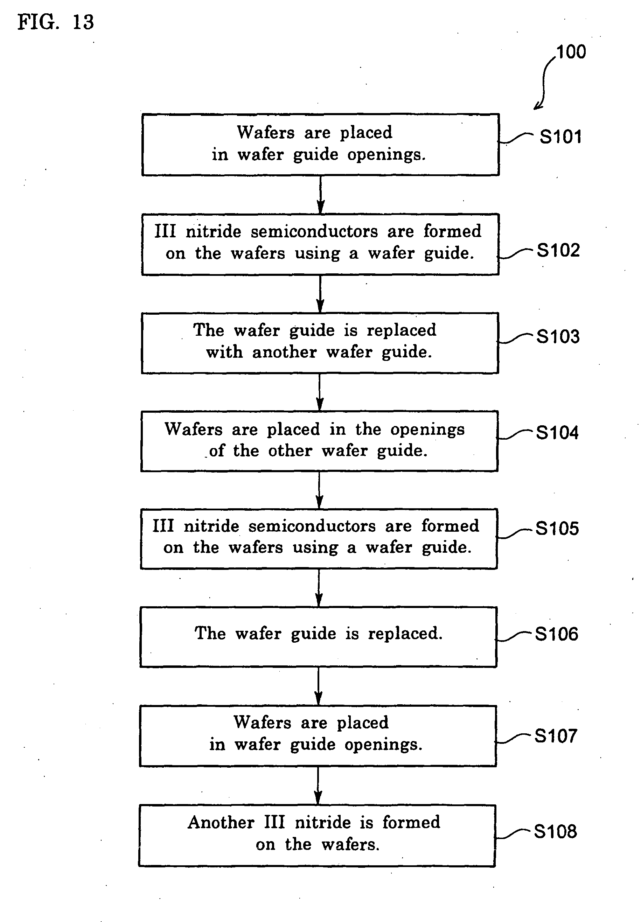

Fig. 13 is a chart explaining a nitride-semiconductor deposition method. Nitride semiconductor is deposited using MOCVD equipment comprehending a wafer guide and wafer support according to the first embodiment. In Step S101 of the flowchart 100, first wafers are placed on a wafer support on which a wafer guide is disposed. In Step S102, a first semiconductor consisting of a Group-III nitride compound is deposited on the first wafers using the wafer guide. In this deposition, a III-nitride compound semiconductor film is grown on the first wafers, and III nitride deposits form on the wafer guide.

With this method, when epitaxial growth is carried out using MOCVD equipment, because III-nitride deposits form not on the wafer support, but on the wafer guide, the wafer guide protects the equipment susceptors from III-nitride deposits. Thus, III-nitride compound semiconductor can be deposited without the effects of III-nitride build-up. The III-nitride compound semiconductor is preferably a gallium nitride semiconductor such as GaN, AlGaN, InGaN, or InAlGaN, and preferably is made up of at least one type of these nitride compound semiconductor layers; and its structure may be such that functionality as a semiconductor is achieved by a laminate of a plurality of such layers. Depending on semiconductor device functions, it is preferable that the III-nitride compound semiconductors be doped to control conductivity. For example, a first III nitride compound semiconductor may employ a blue light emitting diode (LED) structure grown on a monocrystal GaN substrate. In a typical blue LED structure, the layers are, starting from the surface side: Mg-doped GaN / Mg-doped AlGaN / InGaN / GaN quantum well / Si-doped GaN / GaN monocrystal substrate.

After Step S102, in Step S103, a used wafer guide is replaced with another wafer guide. In Step S104, the first wafers are removed and second wafers are placed on the wafer support on which the wafer guide is disposed. In Step S105, second III-nitride compound semiconductor is deposited on the second wafers using the other wafer guide. The second III-nitride compound semiconductor may differ from first III-nitride compound semiconductor in terms of type of elemental constituents or elemental impurities, or in terms of laminar structure. For example, the second III-nitride compound semiconductor may be a high electron mobility transistor (HEMT). A typical HEMT structure is undoped-AlGaN / undoped-GaN / sapphire substrate. Because an HEMT does not require *p*-type conductivity, there is no Mg-doped layer. In an HEMT, to achieve high mobility, impurity concentration needs to be kept low. Mg is said to have a memory effect, and if Mg was used as dopant in the previous growth, even if not used in the next growth, Mg gets mixed in. To avoid this, such measures are taken as extended baking in hydrogen or replacement of susceptor and reaction tube. Mg is mainly contained in nitride deposits on susceptors, and is believed to become incorporated into a film during the deposition process. Therefore, replacing susceptors after Mg-doping is effective. However, because individual differences and such among the susceptors cause lack of uniformity and reduce yield, replacing susceptors is not preferable. With the present method, deposits that would have accumulated on the susceptor accumulate only on the wafer guide. The deposits can be removed simply by wafer guide replacement. Even after Mg doping, no susceptor replacement is required, thus improving productivity and yield. This method is particularly effective when semiconductor device requiring Mg doping―such as LEDs or laser diodes―and semiconductor devices not requiring Mg doping―such as HEMTs―are grown using the same MOCVD equipment.

Following Step S105, in Step S106, the used wafer guide is further replaced with another wafer guide. In Step S107, wafers are replaced and third wafers are set into place; and in Step S108, and even third III-nitride compound semiconductor may be deposited. The third III-nitride compound semiconductor may differ from the second III-nitride compound semiconductor in terms of type of elemental constituents or elemental impurities, or in terms of laminar structure. With this method, just by replacing the wafer guide with another, without replacement of wafer support, various types of III-nitride compound semiconductor can be repeatedly deposited on wafers.

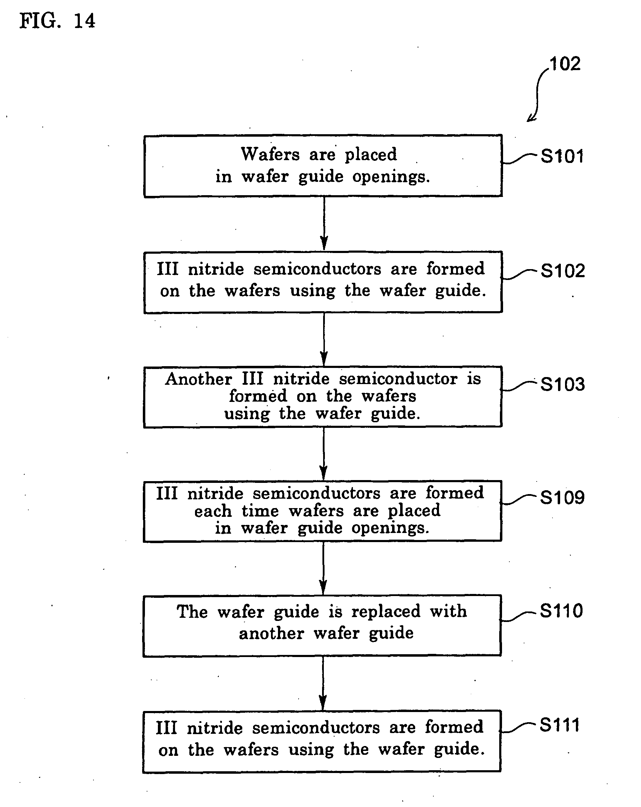

Fig. 14 is a chart explaining a modified example of the nitride semiconductor deposition method. Following Steps S101, S102, S103 of flowchart 102, in Step S109, with every instance of setting fourth wafers on a wafer support on which a wafer guide is disposed, the deposition, using the wafer guide, of III-nitride compound semiconductor on fourth wafers is repeated. Thus repeating the replacement of and deposition onto wafers leads to an increasing amount of deposited matter on the wafer guide, and if the deposited matter comes off and falls on the wafers, it will cause surface defects in the III-nitride compound semiconductors. In such a case, in Step S110, the wafer guide is replaced with another wafer guide. In Step S111, after wafers are placed in openings of this other wafer guide, III-nitride compound semiconductor is deposited on the wafers using this other wafer guide. This method allows, as wafer guides are replaced by other wafer guides, without replacing wafer supports, III-nitride compound semiconductor to be repeatedly deposited on wafers. Steps S109-S111 can be carried out after Step S108.

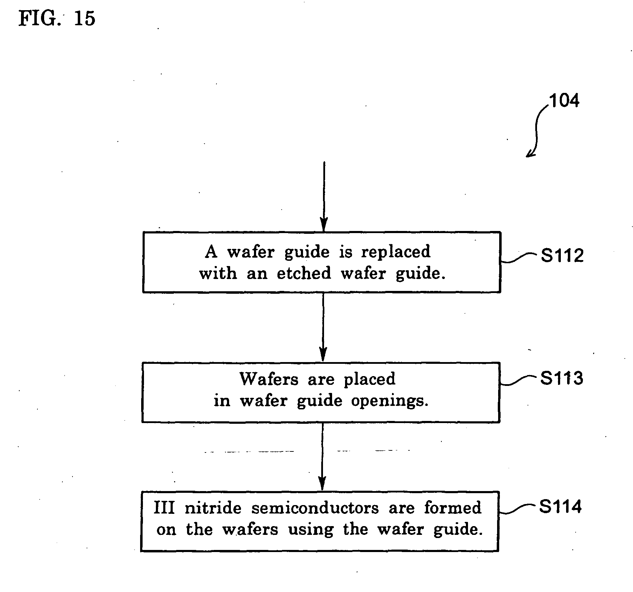

Fig. 15 is a chart explaining a modified example of the nitride semiconductor deposition method. Following Steps S102, S108, S111 of chart 104, in Step S112, a wafer guide on which III nitride deposits have formed is etched, and a used wafer guide is replaced with the etched wafer guide. In Step S113, fifth wafers are placed on a wafer support on which the etched wafer guide has been disposed. In Step S114, fifth III-nitride compound semiconductor is deposited on the fifth wafers using the etched wafer guide. With this method, without wafer support replacement, replacement is made using a revitalized wafer guide, allowing III-nitride compound semiconductor to be repeatedly deposited on wafers.

The technological essence of the present invention has been explained with reference to the drawings as preferred embodiments. A party skilled in the art will recognize that various modifications of disposition and details are possible without departing from such technological essence. The present invention is not limited to the specific configurations explained in the embodiments. For example, the use of a wafer guide is not limited to MOCVD equipment having the specific configurations described in the embodiments.

## Claims

1. An MOCVD tool for growing nitride semiconductor comprising a wafer support (15) and wafer guide (17) to be installed onto the wafer support (15) in the MOCVD equipment, wherein
the wafer support (15) has a carrying surface, the carrying surface comprising one or a plurality of first sections (15a) for carrying wafers (19) on which nitride semiconductor is to be grown, the carrying surface further comprising a second section (15b) having a flat surface;
the one or a plurality of first sections (15a) are formed so that the second section (15b) surrounds the one or a plurality of first sections (15a) ;
the wafer guide (17) comprises a protector (17a) for covering the second section (15b), one or a plurality of openings (17b) in the protector (17a) for receiving said wafers onto a support surface of the one or plurality of the first sections (15a) exposed in each of the one or plurality of openings (17b), and one or a plurality of lateral surfaces (17c) on said protector (17a) defining the one or a plurality of openings (17b) for guiding the wafers,
the first sections (15a) of the carrying surface of the wafer support (15) each are demarcated from the second section (15b) by a step (15c) and have a platform (15e) protruding above the flat surface of the second section (15b) to correspond to the form of the wafers; and
the one or a plurality of lateral surfaces (17c) of the wafer guide (17) are formed to extend along the edges of the one or a plurality of platforms.

2. An MOCVD tool as set forth in claim 1, wherein the wafer guide further comprises positioning sections (49g) for removably positioning the wafer guide (17) with respect to the wafer support.

3. An MOCVD tool as set forth in either claim 1 or 2, wherein the wafer guide (17) is formed of a material resistant to corrosion by phosphoric acid solutions or by solutions containing a mixture of phosphoric acid and sulfuric acid.

4. An MOCVD tool as set forth in claim 3, wherein the wafer guide is formed of a material resistant to corrosion by ammonia gas as well as hydrogen gas.

5. An MOCVD tool as set forth in any of claims 1 through 4, wherein the wafer guide (17) is formed of silicon carbide.

6. An MOCVD tool as set forth in any of claims 1 through 4, wherein the wafer guide (17) is formed of tantalum carbide.

7. An MOCVD tool as set forth in any of claims 1 through 4, wherein the wafer guide (17) is formed of boron nitride.

8. An MOCVD tool as set forth in any of claims 1 through 4, wherein the wafer guide (17) is formed of quartz.

9. An MOCVD tool as set forth in_any of claims 1 though 8, wherein said protector (17a) comprises one or a plurality of extension portions for covering the periphery of the upper surface of the one or a plurality of platforms, and the one or a plurality of lateral surfaces are positioned on the one or a plurality of extension portions.

10. An MOCVD tool as set forth in any of claims 1 through 9, wherein the one or a plurality of lateral surfaces of the protector (17a) each includes a flat surface corresponding to a wafer orientation flat, and a curved surface corresponding to a wafer arc.

11. An MOCVD tool as set forth in any of claims 1 through 9, wherein the one or a plurality of lateral surfaces of said protector (17a) each includes a curved surface corresponding to a wafer arc, and a protrusion corresponding to a wafer orientation flat.

12. A wafer guide as set forth in any of claims 1 through 11, wherein:
said protector (17a) comprises a plurality of protector parts (49);
each protector part comprises a protection portion for partially covering the second section;
said protection parts all combine to define the one or a plurality of wafer-guide openings (17a) and guide the wafers.

13. An MOCVD tool as set forth in any of claims 1 through 12 , wherein the height of the wafer guide (17) is made to match the height of the wafers when on the wafer support (15).

14. A nitride-semiconductor deposition method utilizing MOCVD equipment by using the MOCVD tool according to any of claims 1 through 13, the method comprising:
a step of placing one or more first wafers on the wafer support (15) on which the wafer guide (17) is disposed; and
a step of depositing, utilizing the wafer guide (17), first III-nitride compound semiconductor on the first wafers, wherein
in said deposition step, III nitride accumulates on the wafer guide (17).

15. A method as set forth in claim 14, wherein the III-nitride semiconductor is a gallium nitride semiconducting material.

16. A method as set forth in either claim 14 or claim 15, further comprising:
a step of replacing the installed wafer guide (17) with a different wafer guide (17) according to any of claims 1 through 13;
a first step of placing one or a plurality of second wafers (19) on the wafer support (15)_on which the different wafer guide (17) has been disposed after the replacement of the installed wafer guide (17) with the different wafer guide; and
a step of depositing, utilizing the different wafer guide (17), a second III-nitride compound semiconductor on the one or a plurality of second wafers.

17. A method as set forth in claim 16, wherein the elemental constituents of, type of elemental impurity in, or laminar structure of the second III-nitride compound semiconductor, and the elemental constituents of, type of elemental impurity in, or laminar structure of the first III-nitride compound semiconductor differ.

18. A method as set forth in any of claims 14 through 17, wherein the first III-nitride compound semiconductor contains a layer doped with magnesium, and the second III-nitride compound semiconductor does not contain a layer doped with magnesium.

19. A method as set forth in any of claims 14 through 18, further comprising:
a second step of replacing the installed wafer guide (17) with a different wafer guide (17) according to any of claims 1 through 13; and
a step, prior to replacing the wafer guide after first III-nitride compound semiconductor has accumulated thereon, and with every instance of setting one or a plurality of third wafers on the wafer support (15) on which the wafer guide (17) has been disposed, of repeating deposition, using the wafer guide (17), of the first III-nitride compound semiconductor on the third wafers.

20. A method as set forth in any of claims 14 through 19, further comprising:
a step of, subsequent to the etching of a wafer guide (17) on which III-nitride deposits have formed, placing one or a plurality of fourth wafers on the wafer support (15), with the etched wafer guide (17) having been disposed thereon; and
a step of depositing, using the etched wafer guide, fourth III-nitride compound semiconductor on the fourth wafers.

## Patentansprüche

1. MOCVD-Vorrichtung zum Aufwachsen eines Nitrid-Halbleiters, die einen Wafer-Träger (15) und eine Wafer-Führung (17) umfasst, die in der MOCVD-Anlage auf dem Wafer-Träger (15) installiert wird, wobei
der Wafer-Träger (15) eine Tragefläche aufweist, die Tragefläche einen ersten Abschnitt (15a) oder eine Vielzahl davon zum Tragen von Wafern (19) umfasst, auf denen ein Nitrid-Halbleiter aufgewachsen werden soll, und die Tragefläche des Weiteren einen zweiten Abschnitt (15b) mit einer planen Fläche umfasst;
der eine erste Abschnitt (15a) oder die Vielzahl davon so ausgebildet ist/sind, dass der zweite Abschnitt (15b) den einen ersten Abschnitt (15a) oder die Vielzahl davon umgibt;
die Wafer-Führung (17) eine Schutzeinrichtung (17a) umfasst, die den zweiten Abschnitt (15b) abdeckt, wobei eine Öffnung (17b) in der Schutzeinrichtung (17a) oder eine Vielzahl davon dazu dient/dienen, die Wafer auf einer Tragefläche des einen ersten Abschnitts (15a) oder der Vielzahl davon in der einen Öffnung (17b) oder der Vielzahl davon freiliegend aufzunehmen, und eine seitliche Fläche (17c) an der Schutzeinrichtung (17a) oder eine Vielzahl davon die eine Öffnung (17b) zum Führen der Wafer oder die Vielzahl davon definiert/definieren,
die ersten Abschnitte (15a) der Tragefläche des Wafer-Trägers (15) jeweils durch einen Absatz (15c) von dem zweiten Abschnitt (15b) abgegrenzt sind und eine Plattform (15e) aufweisen, die über die plane Fläche des zweiten Abschnitts (15b) so vorsteht, dass sie der Form der Wafer entspricht; und
die eine seitliche Fläche (17c) der Wafer-Führung (17) oder die Vielzahl davon so ausgebildet ist/sind, dass sie sich an den Rändern der einen Plattform oder der Vielzahl davon entlang erstreckt/erstrecken.

2. MOCVD-Vorrichtung nach Anspruch 1, wobei die Wafer-Führung des Weiteren Positionierabschnitte (49g) zum entfernbaren Positionieren der Wafer-Führung (17) in Bezug auf den Wafer-Träger umfasst.

3. MOCVD-Vorrichtung nach Anspruch 1 oder 2, wobei die Wafer-Führung (17) aus einem Material besteht, das beständig gegenüber Korrosion durch Phosphorsäurelösungen oder durch Lösungen ist, die ein Gemisch aus Phosphorsäure und Schwefelsäure enthalten.

4. MOCVD-Vorrichtung nach Anspruch 3, wobei die Wafer-Führung aus einem Material besteht, das beständig gegenüber Korrosion durch Ammoniakgas sowie Wasserstoffgas ist.

5. MOCVD-Vorrichtung nach einem der Ansprüche 1 bis 4, wobei die Wafer-Führung (17) aus Siliziumkarbid besteht.

6. MOCVD-Vorrichtung nach einem der Ansprüche 1 bis 4, wobei die Wafer-Führung (17) aus Tantalkarbid besteht.

7. MOCVD-Vorrichtung nach einem der Ansprüche 1 bis 4, wobei die Wafer-Führung (17) aus Bornitrid besteht.

8. MOCVD-Vorrichtung nach einem der Ansprüche 1 bis 4, wobei die Wafer-Führung (17) aus Quarz besteht.

9. MOCVD-Vorrichtung nach einem der Ansprüche 1 bis 8, wobei die Schutzeinrichtung (17a) einen Erweiterungsabschnitt oder eine Vielzahl davon umfasst, der/die den Rand der oberen Fläche der einen Plattform oder der Vielzahl davon abdeckt/abdecken, und die eine seitliche Fläche oder eine Vielzahl davon an dem einen Erweiterungsabschnitt oder der Vielzahl davon positioniert ist/sind.

10. MOCVD-Vorrichtung nach einem der Ansprüche 1 bis 9, wobei die eine seitliche Fläche der Schutzeinrichtung (17a) oder die Vielzahl davon jeweils eine plane Fläche, die einer Wafer-Ausrichtabflachung entspricht, und eine gekrümmte Fläche enthält/enthalten, die einem Wafer-Kreisbogen entspricht.

11. MOCVD-Vorrichtung nach einem der Ansprüche 1 bis 9, wobei die eine seitliche Fläche der Schutzeinrichtung (17a) oder die Vielzahl davon jeweils eine gekrümmte Fläche, die einem Wafer-Kreisbogen entspricht, und einen Vorsprung enthält/enthalten, der einer Wafer-Ausrichtabflachung entspricht.

12. Wafer-Führung nach einem der Ansprüche 1 bis 11, wobei:
die Schutzeinrichtung (17a) eine Vielzahl von Schutzteilen (49) umfasst,
jeder Schutzteil einen Schutzabschnitt umfasst, der den zweiten Abschnitt teilweise abdeckt;
alle der Schutzteile zusammen die eine Wafer-Führungsöffnung (17a) oder eine Vielzahl davon definieren und die Wafer führen.

13. MOCVD-Vorrichtung nach einem der Ansprüche 1 bis 12, wobei die Höhe der Wafer-Führung (17a) der Höhe der Wafer entspricht, wenn sie sich auf dem Wafer-Träger (15) befindet.

14. Verfahren zum Abscheiden von Nitrid-Halbleiter mittels einer MOCVD-Anlage unter Verwendung der MOCVD-Vorrichtung nach einem der Ansprüche 1 bis 13, wobei das Verfahren umfasst:
einen Schritt des Auflegens eines ersten Wafers oder mehrerer davon auf den Wafer-Träger (15), an dem die Wafer-Führung (17) angeordnet ist; und
einen Schritt des Abscheidens von erstem III-Nitridverbindungs-Halbleiter auf den ersten Wafern unter Verwendung der Wafer-Führung (17), wobei sich in dem Abscheideschritt III-Nitrid an der Wafer-Führung (17) akkumuliert.

15. Verfahren nach Anspruch 14, wobei der III-Nitrid-Halbleiter ein Galliumnitrid-Halbleitermaterial ist.

16. Verfahren nach Anspruch 14 oder Anspruch 15, das des Weiteren umfasst:
einen Schritt des Austauschens der installierten Wafer-Führung (17) gegen eine andere Wafer-Führung (17) nach einem der Ansprüche 1 bis 13;
einen Schritt des Auflegens eines zweiten Wafers (19) oder einer Vielzahl davon auf den Wafer-Träger (15), an dem die andere Wafer-Führung (17) angeordnet worden ist, nach dem Austauschen der installierten Wafer-Führung (17) gegen die andere Wafer-Führung; und
einen Schritt des Abscheidens eines zweiten III-Nitrid-Verbindungshalbleiters auf dem einen zweiten Wafer oder einer Vielzahl davon unter Verwendung der anderen Wafer-Führung (17).

17. Verfahren nach Anspruch 16, wobei sich die elementaren Bestandteile des zweiten III-Nitrid-Verbindungshalbleiters, der Typ der elementaren Verunreinigung darin oder eine Schichtstruktur desselben und die elementaren Bestandteile des ersten III-Nitrid-Verbindungshalbleiters, der Typ der elementaren Verunreinigung darin oder die Schichtstruktur desselben unterscheiden.

18. Verfahren nach einem der Ansprüche 14 bis 17, wobei der erste III-Nitrid-Verbindungshalbleiter eine mit Magnesium dotierte Schicht enthält und der zweite III-Nitrid-Verbindunghalbleiter keine mit Magnesium dotierte Schicht enthält.

19. Verfahren nach einem der Ansprüche 14 bis 18, das des Weiteren umfasst:
einen zweiten Schritt des Austauschens der installierten Wafer-Führung (17) gegen eine andere Wafer-Führung (17) nach einem der Ansprüche 1 bis 13; und
einen Schritt des Wiederholens der Abscheidung des ersten III-Nitrid-Verbindungshalbleiters auf dritten Wafern unter Verwendung der Wafer-Führung (17) vor dem Austauschen der Wafer-Führung, nachdem sich erster III-Nitrid-Verbindungshalbleiter daran akkumuliert hat, und bei jedem Auflegen eines dritten Wafers oder einer Vielzahl davon auf den Wafer-Träger (15), an dem die Wafer-Führung (17) angeordnet worden ist.

20. Verfahren nach einem der Ansprüche 14 bis 19, das des Weiteren umfasst:
einen Schritt des Auflegens eines vierten Wafers oder einer Vielzahl davon auf den Wafer-Träger (15), an dem eine geätzte Wafer-Führung (17) angeordnet worden ist, nach dem Ätzen der Wafer-Führung (17), an der sich III-Nitridabscheidungen ausgebildet haben; und
einen Schritt des Abscheidens von viertem III-Nitrid-Verbindungshalbleiter auf den vierten Wafern unter Verwendung der geätzten Wafer-Führung.

## Revendications

1. Outil de dépôt chimique métallo-organique en phase vapeur, soit MOCVD, pour faire croître des semi-conducteurs au nitrure, comprenant un support de tranche (15) et un guide de tranche (17) à installer sur le support de tranche (15) dans l'équipement MOCVD, dans lequel :
- le support de tranche (15) possède une surface portante, la surface portante comprenant une ou une pluralité de premières sections (15a) pour supporter des tranches (19) sur lesquelles doit croître un semi-conducteur au nitrure, la surface portante comprenant en outre une seconde section (15b) pourvue d'une surface plane ;
- l'une ou la pluralité de premières sections (15a) sont formées de telle sorte que la seconde section (15b) entoure l'une ou la pluralité de premières sections (15a) ;
- le guide de tranche (17) comprend un dispositif de protection (17a) pour couvrir la seconde section (15b), une ou une pluralité d'ouvertures (17b) dans le dispositif de protection (17a) pour accueillir lesdites tranches sur une surface de support de l'une ou de la pluralité de premières sections (15a) exposées dans chacune de l'une ou de la pluralité d'ouvertures (17b), et une ou une pluralité de surfaces latérales (17c) sur ledit dispositif de protection (17a) définissant l'une ou la pluralité d'ouvertures (17b) pour guider les tranches,
- les premières sections (15a) de la surface portante du support de tranche (15) sont délimitées chacune de la seconde section (15b) par un redent (15c) et présentent une plate-forme (15e) dépassant au-dessus de la surface plane de la seconde section (15b) afin de correspondre à la forme des tranches ; et
- l'une ou la pluralité de surfaces latérales (17c) du guide de tranche (17) sont conformées pour s'étendre le long des bords de l'une ou de la pluralité de plates-formes.

2. Outil MOCVD selon la revendication 1, dans lequel le guide de tranche comprend en outre des sections de positionnement (49g) pour positionner le guide de tranche (17) de manière amovible par rapport au support de tranche.

3. Outil MOCVD selon la revendication 1 ou 2, dans lequel le guide de tranche (17) est constitué d'un matériau résistant à la corrosion par des solutions d'acide phosphorique ou par des solutions contenant un mélange d'acide phosphorique et d'acide sulfurique.

4. Outil MOCVD selon la revendication 3, dans lequel le guide de tranche est constitué d'un matériau résistant à la corrosion par l'ammoniac gazeux ainsi que par l'hydrogène gazeux.

5. Outil MOCVD selon l'une quelconque des revendications de 1 à 4, dans lequel le guide de tranche (17) est constitué de carbure de silicium.

6. Outil MOCVD selon l'une quelconque des revendications de 1 à 4, dans lequel le guide de tranche (17) est constitué de carbure de tantale.

7. Outil MOCVD selon l'une quelconque des revendications de 1 à 4, dans lequel le guide de tranche (17) est constitué de nitrure de bore.

8. Outil MOCVD selon l'une quelconque des revendications de 1 à 4, dans lequel le guide de tranche (17) est constitué de quartz.

9. Outil MOCVD selon l'une quelconque des revendications de 1 à 8, dans lequel ledit dispositif de protection (17a) comprend une ou une pluralité d'éléments d'extension pour couvrir la périphérie de la surface supérieure de l'une ou de la pluralité de plates-formes, et l'une ou la pluralité de surfaces latérales sont positionnées sur l'une ou la pluralité d'éléments d'extension.

10. Outil MOCVD selon l'une quelconque des revendications de 1 à 9, dans lequel l'une ou la pluralité de surfaces latérales du dispositif de protection (17a) comprennent chacune une surface plane correspondant à un méplat d'orientation de tranche, et une surface courbe correspondant à un arc de tranche.

11. Outil MOCVD selon l'une quelconque des revendications de 1 à 9, dans lequel l'une ou la pluralité de surfaces latérales dudit dispositif de protection (17a) comprennent chacune une surface courbe correspondant à un arc de tranche, et une protubérance correspondant à un méplat d'orientation de tranche.

12. Guide de tranche selon l'une quelconque des revendications de 1 à 11, dans lequel :
- ledit dispositif de protection (17a) comprend une pluralité d'éléments de dispositif de protection (49) ;
- chaque élément de dispositif de protection comporte une partie de protection pour couvrir partiellement la seconde section ;
- lesdits éléments de dispositif de protection se combinent tous pour définir l'une ou la pluralité d'ouvertures de guide de tranche (17a) et guident les tranches.

13. Outil MOCVD selon l'une quelconque des revendications de 1 à 12, dans lequel la hauteur du guide de tranche (17) est dimensionnée pour correspondre à la hauteur des tranches lorsqu'elles reposent sur le support de tranche (15).

14. Procédé de dépôt de semi-conducteur au nitrure mettant en oeuvre un équipement MOCVD en utilisant l'outil MOCVD selon l'une quelconque des revendications de 1 à 13, le procédé comprenant :
- une étape consistant à placer une ou plusieurs premières tranches sur le support de tranche (15), sur lequel le guide de tranche (17) est disposé ; et
- une étape de dépôt, utilisant le guide de tranche (17), d'un premier semi-conducteur composé au nitrure III sur les premières tranches, dans laquelle
- dans ladite étape de dépôt, du nitrure III s'accumule sur le guide de tranche (17).

15. Procédé selon la revendication 14, dans lequel le semi-conducteur au nitrure III est un matériau semi-conducteur au nitrure de gallium.

16. Procédé selon la revendication 14 ou 15, comprenant en outre :
- une étape consistant à remplacer le guide de tranche (17) installé par un guide de tranche (17) différent selon l'une quelconque des revendications de 1 à 13 ;
- une première étape consistant à placer une ou une pluralité de deuxièmes tranches (19) sur le support de tranche (15) sur lequel a été disposé le guide de tranche différent (17) après le remplacement du guide de tranche installé (17) par le guide de tranche différent ; et
- une étape consistant à déposer, en utilisant le guide de tranche différent (17), un deuxième semi-conducteur composé au nitrure III sur l'une ou la pluralité de deuxièmes tranches.

17. Procédé selon la revendication 16, dans lequel les constituants élémentaires, le type d'impuretés élémentaires internes, ou la structure laminaire du deuxième semi-conducteur composé au nitrure III, et les constituants élémentaires, le type d'impuretés élémentaires internes, ou la structure laminaire du premier semi-conducteur composé au nitrure III diffèrent.

18. Procédé selon l'une quelconque des revendications de 14 à 17, dans lequel le premier semi-conducteur composé au nitrure III contient une couche dopée au magnésium, et le deuxième semi-conducteur composé au nitrure III ne contient pas de couche dopée au magnésium.

19. Procédé selon l'une quelconque des revendications de 14 à 18, comprenant en outre :
- une seconde étape consistant à remplacer le guide de tranche (17) installé par un guide de tranche (17) différent selon l'une quelconque des revendications de 1 à 13 ; et
- une étape, avant de remplacer le guide de tranche, après l'accumulation sur celui-ci du premier semi-conducteur composé au nitrure III, et pour chaque opération de mise en place d'une ou d'une pluralité de troisièmes tranches sur le support de tranche (15) sur lequel le guide de tranche (17) a été disposé, de répétition, en utilisant le guide de tranche (17), du dépôt du premier semi-conducteur composé au nitrure III sur les troisièmes tranches.

20. Procédé selon l'une quelconque des revendications de 14 à 19, comprenant en outre :
- une étape consistant, après la gravure d'un guide de tranche (17) sur lequel des dépôts de nitrure III se sont formés, à placer une ou une pluralité de quatrièmes tranches sur le support de tranche (15), le guide de tranche (17) gravé ayant été placé sur celui-ci ; et
- une étape consistant à déposer, en utilisant le guide de tranche gravé, un quatrième semi-conducteur composé au nitrure III sur les quatrièmes tranches.
